# EUROPÄISCHE PATENTSCHRIFT

(11) **EP 3 802 908 B1**
(45) Veröffentlichungstag und Bekanntmachung des Hinweises auf die Patenterteilung: **01.07.2026**
(21) Anmeldenummer: 19719807.0
(22) Anmeldetag: 18.04.2019
(51) Int. Cl.: C23C 14/50, C23C 14/56, C23C 14/16, C23C 14/02, F27B 9/04, B65H 23/02, B65H 23/032, F27B 9/28

(54) **VAKUUMBESCHICHTUNGSANLAGE, UND VERFAHREN ZUM BESCHICHTEN EINES BANDFÖRMIGEN MATERIALS**
VACUUM-COATING SYSTEM AND METHOD FOR COATING A BAND-TYPE MATERIAL
INSTALLATION DE REVÊTEMENT SOUS VIDE ET PROCÉDÉ POUR MUNIR UN MATÉRIAU EN FORME DE BANDE D'UN REVÊTEMENT

(30) Priorität: 28.05.2018 DE 102018208339; 05.09.2018 DE 102018215102
(43) Veröffentlichungstag der Anmeldung: 14.04.2021
(73) Patentinhaber: SMS group GmbH, 41069 Mönchengladbach (DE)
(72) Erfinder: KÜMMEL, Lutz, 41363 Jüchen (DE); DAUBE, Thomas, 47279 Duisburg (DE)
(74) Vertreter: Kross, Ulrich
(86) Internationale Anmeldenummer: PCT/EP2019/060156
(87) Internationale Veröffentlichungsnummer: WO 2019/228709

(56) Entgegenhaltungen:
- WO-A1-2012/034587
- JP-A- 2008 031 505
- US-A1- 2016 340 776

## Beschreibung

Die Erfindung betrifft eine Vakuumbeschichtungsanlage nach dem Oberbegriff von Anspruch 1, und ein Verfahren zum Beschichten eines bandförmigen Materials nach dem Oberbegriff von Anspruch 3.

Bei der Herstellung von Stahlbändern kommt es sowohl beim Warmwalzen als auch beim Kaltwalzen zu Breitenänderungen des Bandes über der Länge. Dies wird durch die sogenannte "Breitung" verursacht, welche eine Zunahme der Breite des gewalzten Bandes von einigen Millimetern durch den Walzstich zur Folge hat. Die unterschiedliche Breitung über der Länge des Stahlbandes ist in der Regel auf Zugschwankungen innerhalb der Anlage, mit der das Stahlband bearbeitet wird, zurückzuführen.

Eine weitere Problematik beim Walzen von Stahlbändern besteht darin, dass durch den Walzprozess Rand- oder Mittelwellen durch unterschiedliche Verlängerung über den Querschnitt entstehen können.

Bei der Herstellung von bandförmigem Material, z.B. in Form von Stahlbändern, ist es nach dem Stand der Technik bekannt, die Oberflächen dieses bandförmigen Materials zu verzinken. Dies kann durch einen Vakuumbedampfungsprozess erfolgen, wie z.B. aus DE 30 35 000 A1, DE 195 27 515 C1 oder DE 197 35 603 C1 bekannt. Zu diesem Vakuumbedampfungsprozess zählt auch die sogenannte PVD- Technologie, die z.B. in der DE 10 2009 053 367 A1 erläutert ist.

Bei dem vorstehend genannten Vakuumbedampfungsprozess erfolgt das Beschichten des bandförmigen Materials in Vakuum, wobei das bandförmige Material durch eine Schleuse und/oder ein System von Blendenelementen einer Kammer oder dergleichen zugeführt wird, in der Vakuum besteht bzw. erzeugt ist. Die Abdichtung des in der Kammer erzeugten Vakuums gegenüber der Umgebung erfolgt in der Regel über Dichtmittel in Form von Blendenelementen, was z.B. in der WO 2008/049523 A1 im Zusammenhang mit einer Bandschleuse beschrieben ist. Eine solche Abdichtung kann gemäß EP 1 004 369 B1 auch durch eine Schleuse mit einer Mehrzahl von Walzen realisiert werden, wobei zumindest eine Walze in Bezug auf mindestens zwei andere Walzen versetzt angeordnet ist und mit ihrer Distanz zu diesen zwei anderen Walzen eingestellt werden kann, um eine Abdichtung für das bandförmige Material, das zwischen diesen Walzen hindurchbewegt wird, zu erreichen.

Falls ein bandförmiges Material nach dem Prinzip des Vakuumbedampfungsprozess beschichtet wird, kommt der Abdichtung des Vakuums gegenüber der Umgebung eine große Bedeutung zu. Zu diesem Zweck weist die Vakuumkammer, in der die Beschichtung des bandförmigen Materials realisiert wird, an der Einlassseite und Auslassseite jeweils Schleusen auf. Falls das bandförmige Material über seiner Bandlänge Planheitsfehler aufweisen sollte, die durch vorgelagerte Wärmebehandlungprozesse entstehen können, kann dies im Bereich der Schleusen der Vakuumkammer entweder zu einem erhöhten Verschleiß oder gar zu einem Einbruch des Vakuums führen, wodurch der Beschichtungsprozess unter Vakuum gestört wird. Hinzu tritt, dass solche Planheitsfehler innerhalb der Vakuumkammer zu veränderten Abständen zwischen den Oberflächen des zu beschichtendes bandförmigen Materials und den Beschichtungs- und Reinigungsmodulen führt, wodurch der Vakuum-Beschichtungsprozess ebenfalls beeinträchtigt wird.

Aus US 2003/221618 A1 und US 2004/159285 A1 sind jeweils eine Vakuumbeschichtungsanlage nach dem Oberbegriff von Anspruch 1 und ein Verfahren zum Beschichten eines bandförmigen Materials nach dem Oberbegriff von Anspruch 3 bekannt.

US 2016/0340776 A1 zeigt eine Vakuumbeschichtungsanlage mit einer Vakuumkammer, in der stromaufwärts bzw. vor einer Verarbeitungswalze ein Rollenkörper angeordnet ist. Um diesen Rollenkörper herum wird ein bandförmiges Material von einer Seite her teilweise herumgeführt und hierbei von dem Rollenkörper auf eine gewünschte Temperatur gebracht, bevor das bandförmige Material anschließend in Kontakt mit der Verarbeitungswalze gelangt. Weiterer relevanter Stand der Technik ist in dem Patentdokument WO 2012/034587A1 offenbart.

Entsprechend liegt der Erfindung die Aufgabe zugrunde, das Beschichten von bandförmigem Material unter Vakuum mit einfachen Mitteln zu optimieren und hierfür eine verbesserte Prozesssicherheit zu erreichen.

Diese Aufgabe wird durch eine Vakuumbeschichtungsanlage gemäß Anspruch 1 und durch ein Verfahren mit den in Anspruch 3 angegebenen Merkmalen gelöst. Vorteilhafte Weiterbildungen der Erfindung sind in den abhängigen Ansprüchen definiert.

Eine Vakuumbeschichtungsanlage nach der vorliegenden Erfindung dient zum Beschichten eines bandförmigen Materials aus Metall, und umfasst eine Förderstrecke mit Transportmitteln insbesondere in Form von Walzen, auf denen das bandförmige Material in einer Transportrichtung bewegt werden kann, eine Beschichtungskammer, in der Vakuum erzeugbar ist, wobei die Beschichtungskammer einen Einlassbereich und einen Auslassbereich aufweist und dadurch von dem bandförmigen Material entlang bzw. auf der Förderstrecke in der Transportrichtung durchlaufen werden kann. In Transportrichtung des bandförmigen Materials gesehen ist stromaufwärts der Beschichtungskammer zumindest eine Planheitsoptimierungseinrichtung angeordnet, durch die das bandförmige Material aus Metall hindurchgeführt werden kann, um dafür eine gewünschte Planheit zu erzeugen. Die Planheitsoptimierungseinrichtung ist als Kompakteinheit ausgebildet, bei der eine Biegerichteinrichtung und ein Streckrichter zu einer Streck-/Biegerichteinrichtung kombiniert sind.

In gleicher Weise sieht die Erfindung auch ein Verfahren zum Beschichten eines bandförmigen Materials insbesondere aus Metall vor, bei dem das bandförmige Material über eine Förderstrecke in einer Transportrichtung bewegt und innerhalb einer Beschichtungskammer, in der ein Vakuum angelegt ist, vakuumbeschichtet wird. Hierbei wird das bandförmige Material - in Transportrichtung des bandförmigen Materials gesehen - stromaufwärts der Beschichtungskammer bezüglich seiner Planheit durch eine Planheitsoptimierungseinrichtung optimiert wird. Dies erfolgt durch die Planheitsoptimierungseinrichtung, die eine Streck-/Biegerichteinrichtung aufweist, mittels der eine Bandverlängerung des bandförmigen Materials in dessen Längsrichtung erzeugt wird.

Der Erfindung liegt die wesentliche Erkenntnis zugrunde, dass ein bandförmiges Material, bevor es in die unter Vakuum gesetzte Beschichtungskammer einer Vakuumbeschichtungsanlage einläuft, in Bezug auf seine Planheit optimiert wird. Zu diesem Zweck durchläuft das bandförmige Material in einem Bereich, der sich - in Transportrichtung des bandförmigen Materials gesehen - stromaufwärts der Beschichtungskammer der Vakuumbeschichtungsanlage befindet, die Planheitsoptimierungseinrichtung, so dass damit an den Oberflächen des bandförmigen Materials eine gewünschte Planheit eingestellt wird und jedenfalls mögliche Planheitsfehler eliminiert werden. In Folge dessen läuft das bandförmige Material mit einer an seinen Oberflächen optimierten Planheit anschließend in die unter Vakuum gesetzte Beschichtungskammer ein. Die optimierte Planheit an den Oberflächen des bandförmigen Materials wirkt sich auch vorteilhaft beim Durchlaufen des Einlassbereichs und des Auslassbereichs der Beschichtungskammer und der dort vorgesehenen Schleusen aus, im Hinblick auf die erforderliche Abdichtung des Vakuums.

In Bezug auf die Planheitsoptimierungseinrichtung darf an dieser Stelle gesondert darauf hingewiesen werden, dass diese erfindungsgemäß neben der Streck-/einrichtung auch eine Dressiergerüsteinrichtung aufweisen kann.

In vorteilhafter Weiterbildung der Erfindung kann vorgesehen sein, dass mittels der Planheitsoptimierungseinrichtung an den Oberflächen des bandförmigen Materials nicht nur eine erforderliche Planheit, sondern auch eine vorbestimmte Rauheit eingestellt wird. Zu diesem Zweck eignet sich insbesondere eine Dressiergerüsteinrichtung, die Bestandteil der Planheitsoptimierungseinrichtung sein kann.

Mittels der Planheitsoptimierungseinrichtung wird eine Bandverlängerung für das bandförmige Material, d.h. eine Verlängerung des Bands in dessen Längserstreckung, erreicht, in einem Bereich von 0,15 % bis 12%. Zu diesem Zweck umfasst die Planheitsoptimierungseinrichtung eine Streck-/Biegerichteinrichtung, die Bestandteil der Planheitsoptimierungseinrichtung ist. Durch eine solche Bandverlängerung wird im Ergebnis für das bandförmige Material eine Feineinstellung von Dickentoleranzen erzielt, was insbesondere bei der Bearbeitung von Warmbändern von Vorteil ist.

Mögliche Untergrenzen für eine solche Bandverlängerung können neben den genannten 0,15% auch folgende Werte sein: 0,2%, 0,25%, 0,3%, 0,35%, 0,4%, 0,45%, 0,5%, 0,55%, 0,6%, 0,65%, 0,7%, 0,75%, 0,8%, 0,85%, 0,9%, 0,95%, 1,0%, 1,05%, 1,1%, 1, 15%, 1, 2%, 1,25%, 1,3%, 1, 35%, 1,4%, 1,45%, 1,5%, 1,65%, 1,7%, 1,75%, 1,8%, 1,85%, 1,9%, 2,0%, 2,05%, 2,1 %, 2,15 %, 2,2 %, 2,25 %, 2,3 %, 2,35 %, 2,4 %, 2,45 %, 2,5 %, 2,55 %, 2,6 %, 2,65 %, 2,7 %, 2,75 %, 2,8 %, 2,85 %, 2,9 %, 2,95 %, 3,0 %, 3,05% etc. Weitere Untergrenzen sind bis 11% möglich, wobei Zwischenwerte von jeweils 0,05% möglich sind, wie soeben bis zur Grenze von 3,05% beispielhaft genannt.

Mögliche Obergrenzen für eine solche Bandverlängerung können neben den genannten 12% auch folgende Werte sein: 11, 95%, 11,9 %, 11,85%, 11,8 %, 11,75 %, 11,7 %, 11,65 %, 11,6 %, 11,55 %, 11,5 %, 11,45 %, 11,4 %, 11,35 %, 11,3 %, 11,25 %, 11,2 %, 11,15 %, 11,1 %, 11,05 %, 11,0 %, 10,95 %, 10,9 %, 10,85%, 10,8 %, 10,75 %, 10,7 %, 10,65 %, 10,6 %, 10,55 %, 10,5 %, 10,45 %, 10,4 %, 10,35 %, 10,3 %, 10,25 %, 10,2 %, 10,15 %, 10,1 %, 10,05 %, 10,0 %, 9,95 %, 9,9 %, 9,85 %, 9,8 %, 9,75 %, 9,7 %, 9,65 %, 9,6 %, 9,55 %, 9,5 %, 9,45 %, 9,4 %, 9,35 %, 9,3 %, 9,25 %, 9,2 %, 9,15 %, 9,1 %, 9,0 %, 8,95 %, etc. Weitere Obergrenzen sind bis zu 1%% möglich, wobei Zwischenwerte von jeweils 0,05% möglich sind, wie soeben bis zur Grenze von 8,95% beispielhaft genannt.

Mit der vorliegenden Erfindung lässt sich vorteilhaft eine Beschichtung von bandförmigem Material unter Vakuum realisieren, das aus Stahlband besteht und einen Gefügeanteil von mindestens 10% Martensit aufweist. Ein solches Stahlband kann weiterhin 0,1 - 0,4% Kohlenstoff, 0,5 - 2,0 % Silizium und/oder 1,5-3,0% Mangan enthalten. Solche Stähle können als "Dualphasenstähle" (DP), "Komplexphasenstahl" (CP), "Quenching and Partitioning Stähle" (Q&P) oder als "Martensitische Stähle" (MS) vorliegen, die jeweils einen unterschiedlichen Gehalt an Martensiten (mit zumindest 10%) haben.

Nachstehend ist eine bevorzugte Ausführungsform der Erfindung anhand einer schematisch vereinfachten Zeichnung im Detail beschrieben. Es zeigen:
- Fig. 1: eine schematisch vereinfachte Seitenansicht einer erfindungsgemäßen Vakuumbeschichtungsanlage, mit der auch ein Verfahren nach der vorliegenden Erfindung durchgeführt werden kann, und
- Fig. 2: eine schematisch vereinfachte Seitenansicht einer Streck-/Biegerichteinrichtung, die Teil der Vakuumsbeschichtungsanlage von Fig. 1 ist.

Die vorliegende Erfindung sieht eine Vakuumbeschichtungsanlage 10 vor, mit der ein bandförmiges Material 11 an zumindest einer Seite davon, vorzugsweise an beiden Seiten (Oberseite und Unterseite) mit einer Beschichtung versehen werden kann. Entsprechend kann mit einer solchen Vakuumbeschichtungsanlage 10 auch ein Verfahren durchgeführt werden, um das bandförmige Material 11 insbesondere zu beschichten. Gleiche Merkmale in den beiden Figuren der Zeichnung sind jeweils mit gleichen Bezugszeichen versehen. An dieser Stelle wird gesondert darauf hingewiesen, dass die Zeichnung lediglich vereinfacht und insbesondere ohne Maßstab dargestellt ist.

Das bandförmige Material 11 kann aus Metall bestehen, insbesondere aus Stahl oder Edelstahl oder entsprechenden Legierungen hiervon. Des Weiteren wird darauf hingewiesen, dass es sich bei dem bandförmigen Material 11, welches mit der Vakuumbeschichtungsanlage 10 beschichtet wird, um Warmband oder Kaltband handeln kann.

Nachfolgend sind die Vakuumbeschichtungsanlage 10, die einzelnen Komponenten hiervon und deren Funktionsweise im Detail erläutert:
Die Vakuumbeschichtungsanlage 10 umfasst eine Förderstrecke 12 mit (nicht gezeigten) Transportmitteln, z.B. in Form von Walzen, auf denen das bandförmige Material in einer Transportrichtung T bewegt wird. Hierbei wird das bandförmige Material 11 am Einlauf der Förderstrecke 12 von einer ersten Haspeleinrichtung 46 abgewickelt, wobei das bandförmige Material 11 - nach Durchführung bzw. Abschluss der gewünschten Beschichtung - am Auslauf der Förderstrecke 12 von einer zweiten Haspeleinrichtung 48 wieder aufgewickelt wird. Direkt nach der ersten Haspeleinrichtung 46 und vor der zweiten Haspeleinrichtung 48 können (Band-)Speicher 44 vorgesehen sein, mit bzw. in denen das bandförmige Material 11 gespeichert werden kann. Innerhalb der Förderstrecke 12 wird das bandförmige Material 11 in der Bewegungsrichtung T bewegt bzw. transportiert, nämlich von der ersten Haspeleinrichtung 46 in Richtung der zweiten Haspeleinrichtung 48.

Entlang der Förderstrecke 12 ist eine Beschichtungskammer 14 angeordnet, durch die hindurch das bandförmige Material 11 bewegt wird. Zu diesem Zweck weist die Beschichtungskammer 14 einen Einlassbereich 16 und einen Auslassbereich 18 auf, wobei in dem Einlassbereich 16 eine Einlaufschleuse 20 und in dem Auslaufbereich 18 eine Auslaufschleuse 22 vorgesehen sind. In der Beschichtungskammer 14 wird Vakuum erzeugt. Hierbei gewährleisten die Einlaufschleuse 20 und die Auslaufschleuse 22 eine geeignete Abdichtung dieses Vakuums gegenüber der äußeren Umgebung, bei gleichzeitiger Bewegung des bandförmigen Materials 11 entlang der Förderstrecke 12 bzw. durch diese beiden Schleusen 20, 22 hindurch.

Die Beschichtungskammer 14 ist mehrteilig ausgebildet und weist einen Beschichtungsteil 26 und einen Reinigungsteil 28 auf. Beide dieser Teile 26 und 28 sind - wie vorstehend bereits erläutert - unter Vakuum gesetzt. In dem Beschichtungsteil 26 wird das eigentliche Beschichten des bandförmigen Materials 11 durchgeführt, z.B. nach dem Prinzip der "PVD" (*= physical vapor deposition*)*,* an entweder einer Seite des bandförmigen Materials oder an beiden Seiten hiervon.

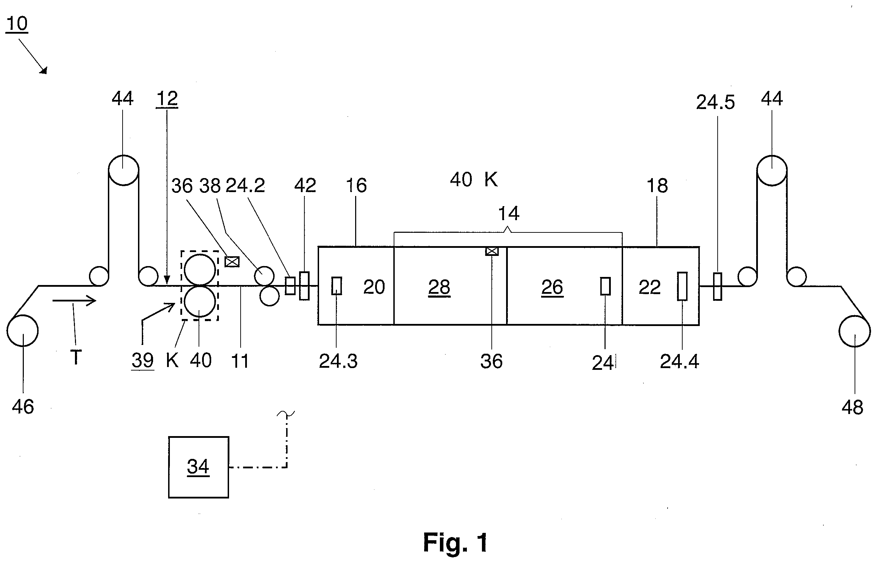

Innerhalb der Beschichtungskammer 14 kann zumindest eine Bandlagenregeleinrichtung 24 angeordnet sein, z.B. innerhalb des Beschichtungsteil 26, wie in der Fig. 1 gezeigt. Ergänzend oder alternativ ist es möglich, eine solche Bandlagenregeleinrichtung 24 in dem Reinigungsteil 28 anzuordnen.

Die Vakuumbeschichtungsanlage 10 umfasst eine Steuerungseinrichtung (in Fig. 1 nur vereinfacht durch ein Blocksymbol mit dem Bezugszeichen "34" gezeigt), die in Signalverbindung (drahtgebunden, oder drahtlos z.B. über eine Funkstrecke oder dergleichen) mit zumindest einem Positionssensor 36 steht. Dieser Positionssensor 36 kann in der Beschichtungskammer 14 angeordnet sein, zwecks Bestimmung der Position des bandförmigen Materials 11 auf der Förderstrecke 12 insbesondere in Bezug auf deren Mittenbereich.

Mittels der Bandlagenregeleinrichtung 24 ist es möglich, eine Position des bandförmigen Materials 11 in Bezug auf eine Mitte der Förderstrecke 12 einzustellen bzw. auszurichten. Dies erfolgt dadurch, dass eine Position des bandförmigen Materials 11 auf der Förderstrecke 12 durch den Positionssensor 36 innerhalb der Beschichtungskammer 14 detektiert wird, wobei anschließend - bei Bedarf - (nicht gezeigte) Stellglieder der Bandlagenregeleinrichtung 24 durch die Steuerungseinrichtung 34 angesteuert werden, um das bandförmige Material 11 in Bezug auf die Mitte der Förderstrecke 12 und senkrecht zur Transportrichtung T auszurichten. Entsprechend kann das bandförmige Material 11 innerhalb der unter Vakuum gesetzten Beschichtungskammer 14 stets optimal positioniert werden, so dass z.B. ein "Anecken" bzw. eine Berührung des bandförmigen Materials 11 mit Seitenwänden der Beschichtungskammer 14 bzw. des Beschichtungsteil 26 während einer Bewegung des bandförmigen Materials 11 entlang der Förderstrecke 12 verhindert wird.

Des Weiteren kann vorgesehen sein, dass innerhalb der Einlaufschleuse 20 und/oder innerhalb der Auslaufschleuse 22 weitere Bandlagenregeleinrichtungen 24.3, 24.4 angeordnet sind. Ebenfalls ist es möglich, dass eine weitere Bandlagenregeleinrichtung 24.2 - in Transportrichtung T des bandförmigen Materials 11 gesehen - stromaufwärts der Einlaufschleuse 20 angeordnet ist, und/oder dass eine weitere Bandlagenregeleinrichtung 24.5 - in Transportrichtung T des bandförmigen Materials 11 gesehen - stromabwärts der Auslaufschleuse 22 angeordnet ist.

In Transportrichtung T des bandförmigen Materials 11 gesehen kann stromaufwärts der Einlaufschleuse 20 eine weitere chemische Reinigungseinrichtung 42 angeordnet sein, die von dem bandförmigen Material 11 vor einem Einlaufen in die Beschichtungskammer 14 durchlaufen wird. Hierdurch werden die Oberflächen des bandförmigen Materials 11, bevor es in dem Reinigungsteil 28 (unter Vakuum) einer Feinreinigung unterzogen wird, vorbereitend gesäubert bzw. gereinigt.

Die Vakuumbeschichtungsanlage 10 umfasst zumindest eine Planheitsoptimierungseinrichtung 39, die eine Dressiergerüsteinrichtung 40 aufweist und - in Transportrichtung T des bandförmigen Materials 11 gesehen - stromaufwärts der Einlaufschleuse 20 angeordnet ist. Das bandförmige Material 11 durchläuft die Dressiergerüsteinrichtung 40, bevor es anschließend in die Beschichtungskammer 14 einläuft. Durch den Kontakt mit den Walzen der Dressiergerüsteinrichtung 40 wird die Planheit an den Oberflächen des bandförmigen Materials 11 auf einen gewünschten Wert eingestellt, wobei gleichzeitig mögliche Planheitsfehler an den Oberflächen des bandförmigen Materials 11 eliminiert werden.

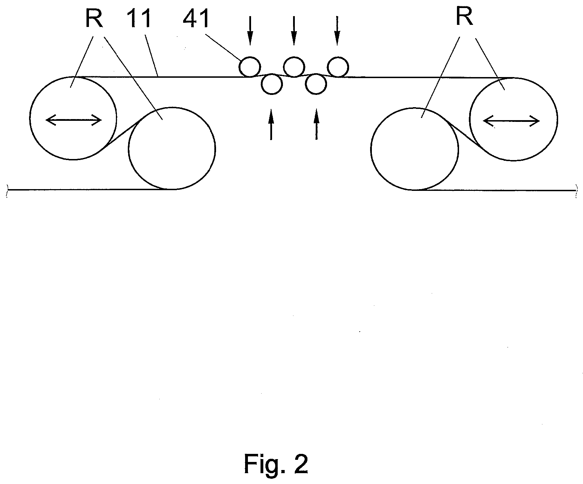

Fig. 2 zeigt eine vereinfachte Seitenansicht einer Streck-/Biegerichteinrichtung 41, die nach einer weiteren Ausführungsform der Erfindung Bestandteil der Planheitsoptimierungseinrichtung 39 sein kann, ergänzend oder alternativ zu der genannten Dressiergerüsteinrichtung 40. Durch die Bezeichnung "K" und das zugeordnete gestrichelte Rechteck in Fig. 1 ist vereinfacht symbolisiert, dass die Planheitsoptimierungseinrichtung 39 auch als eine Kompakteinheit ausgebildet sein kann, die sowohl eine Dressiergerüsteinrichtung 40 als auch eine Streck-/Biegerichteinrichtung 41 umfasst.

Mittels der Streck-/Biegerichteinrichtung 41 und einer Anstellung von deren Walzen, was in Fig. 2 durch entsprechende vertikale Pfeile symbolisiert ist, können die Planheit des bandförmigen Materials 11 an dessen Oberflächen weiter verbessert werden und ggf. auch eine Bandverlängerung, d.h. eine Längung des bandförmigen Materials 11 in dessen Längsrichtung erzielt werden. Zu diesem Zweck können angrenzend zu der Streck-/Biegerichteinrichtung 41 Rollen R vorgesehen sein, um die herum das bandförmige Material 11 geschlungen geführt ist, wobei mittels dieser Rollen R ein gezielter Bandzug auf das bandförmige Material 11 aufgebracht werden kann. Hierzu können z.B. die jeweils außen angeordneten Rollen R z.B. translatorisch horizontal bewegt werden, was in Fig. 2 durch entsprechende horizontale Doppelpfeile kenntlich gemacht ist.

Die Vakuumbeschichtungsanlage 10 umfasst zumindest eine Besäumschere 38, in Transportrichtung T des bandförmigen Materials 11 gesehen stromaufwärts der Einlaufschleuse 20 der Beschichtungskammer 14. Angrenzend hierzu ist zumindest ein weiterer Positionssensor 36 vorgesehen, mit dem eine Position des bandförmigen Materials 11 auf der Förderstrecke 12 in einem Bereich stromaufwärts der Beschichtungskammer 14, und damit auch im Bereich der Besäumschere 38, bestimmt werden kann. Dieser Positionssensor 36 ist ebenfalls mit der Steuerungseinrichtung 34 signaltechnisch verbunden. Entsprechend ist es mittels der Steuerungseinrichtung 34 möglich, die Besäumschere 38 in Abhängigkeit von Signalen des Positionssensors 36 zu betätigen bzw. in Aktion zu setzen.

Die signaltechnische Verbindung zwischen der Steuerungseinrichtung 34 einerseits, und den Positionssensoren 36, den Bandlagenregeleinrichtungen 24 und der Besäumschere 38 andererseits, ist in der Fig. 1 vereinfacht durch eine strichpunktierte Linie symbolisiert.

Die Besäumschere 38 dient zu dem Zweck, das bandförmige Material 11 an entweder einer Bandkante davon, oder wahlweise an beiden Bandkanten (d.h. am linken und rechten Seitenrand des bandförmigen Materials 11) zu besäumen, d.h. dort durch ein Schneiden schmaler zu machen und dadurch die Breite des bandförmigen Materials 11 senkrecht zur Transportrichtung T zu vermindern. Die Besäumschere 38 wird im Betrieb der Vakuumbeschichtungsanlage 10 und bei einer entsprechenden Bewegung des bandförmigen Materials 11 entlang der Förderstrecke 12 dann betätigt, wenn durch den Positionssensor 36 erkannt wird, dass eine Breite des bandförmigen Materials 11 von einem vorbestimmten Sollwert abweicht und z.B. infolge einer Breitung zu groß ist. Durch das Besäumen wird erreicht, dass das bandförmige Material 11 in dem Bereich stromaufwärts der Einlaufschleuse 20, und damit vor dem Einlaufen hinein in die Beschichtungskammer 14, eine gleichbleibende Breite über dessen Länge erhält, wobei diese Breite auch optimal an die Breite der Einlaufschleuse 20 angepasst ist.

Durch ein Hindurchführen des bandförmigen Materials 11 durch die Beschichtungskammer 14 wird zumindest auf eine Oberfläche des bandförmigen Materials 11, vorzugsweise auf beide Oberflächen davon, eine Beschichtung aufgebracht, z.B. eine Zinkschicht. Dieses Beschichten kann innerhalb des Beschichtungsteil 26 nach dem Prinzip der PVD erfolgen. Nachdem zumindest eine Oberfläche des bandförmigen Materials 11 mit einer Beschichtung, z.B. mit einer Zinkschicht, versehen worden sind, wird das bandförmige Material 11 dann wie erläutert von der zweiten Haspeleinrichtung 12 wieder aufgewickelt.

Somit gelingt mit der vorliegenden Erfindung das Aufbringen einer Beschichtung auf eine bzw. die Oberfläche(n) des bandförmigen Materials 11 bei nur geringen Temperaturen, ohne dass die Materialeigenschaften des bandförmigen Materials 11 verändert bzw. beeinträchtigt werden. Dies ist insbesondere dann von Vorteil, wenn es sich bei dem bandförmigen Material um ein Stahlband insbesondere in Form von Warmband handelt, welches einen Gefügeanteil von mindestens 10% Martensit aufweist.

### Bezugszeichenliste

- 10: Vakuumbeschichtungsanlage
- 11: bandförmiges Material
- 12: Förderstrecke
- 14: Beschichtungskammer
- 16: Einlassbereich
- 18: Auslassbereich
- 20: Einlaufschleuse
- 22: Auslaufschleuse
- 24: Bandlagenregeleinrichtung
- 24.2: Bandlagenregeleinrichtung
- 24.3: Bandlagenregeleinrichtung
- 24.4: Bandlagenregeleinrichtung
- 26: Beschichtungsteil
- 28: Reinigungsteil
- 34: Steuerungseinrichtung
- 36: Positionssensor
- 38: Besäumschere
- 39: Planheitsoptimierungseinrichtung
- 40: Dressiergerüsteinrichtung
- 41: Streck-/Biegerichteinrichtung
- 42: chemische Reinigungseinrichtung
- 44: Speicher
- 46: erste Haspeleinrichtung (Einlauf)
- 48: zweite Haspeleinrichtung (Auslauf)
- K: Kompakteinheit (= Dressiergerüsteinrichtung 40 + Streck- /Biegerichteinrichtung 41)
- R: Rollen (zur Erzeugung von Bandzug)
- T: Transportrichtung (für das bandförmige Material 11)

## Patentansprüche

1. Vakuumbeschichtungsanlage (10) zum Beschichten eines bandförmigen Materials (11) aus Metall, umfassend
eine Förderstrecke (12) mit Transportmitteln insbesondere in Form von Walzen, auf denen das bandförmige Material (11) in einer Transportrichtung (T) bewegbar ist,
eine Beschichtungskammer (14), in der Vakuum erzeugbar ist, wobei die Beschichtungskammer (14) einen Einlassbereich (16) und einen Auslassbereich (18) aufweist und dadurch von dem bandförmigen Material (11) entlang bzw. auf der Förderstrecke (12) in der Transportrichtung (T) durchlaufbar ist,
wobei - in Transportrichtung (T) des bandförmigen Materials (11) gesehen - stromaufwärts der Beschichtungskammer (14) zumindest eine Planheitsoptimierungseinrichtung (39) angeordnet ist, durch die das bandförmige Material (11) aus Metall hindurchführbar ist, um dafür eine gewünschte Planheit zu erzeugen,
**dadurch gekennzeichnet,**
**dass** die Planheitsoptimierungseinrichtung (39) als Kompakteinheit (K) ausgebildet ist, bei der eine Biegerichteinrichtung (41) und ein Streckrichter zu einer Streck-/Biegerichteinrichtung (41) kombiniert sind.

2. Vakuumbeschichtungsanlage (10) nach Anspruch 1, **dadurch gekennzeichnet, dass** die Planheitsoptimierungseinrichtung (39) zusätzlich eine Dressiergerüsteinrichtung (40) aufweist.

3. Verfahren zum Beschichten eines bandförmigen Materials (11) insbesondere aus Metall, bei dem das bandförmige Material (11) über eine Förderstrecke (12) in einer Transportrichtung (T) bewegt und innerhalb einer Beschichtungskammer (14), in der ein Vakuum angelegt ist, vakuumbeschichtet wird,
wobei das bandförmige Material (11) - in Transportrichtung (T) des bandförmigen Materials (11) gesehen - stromaufwärts der Beschichtungskammer (14) bezüglich seiner Planheit durch eine Planheitsoptimierungseinrichtung (39) optimiert wird, **dadurch gekennzeichnet,**
**dass** die Planheitsoptimierungseinrichtung (39) eine Streck-/Biegerichteinrichtung (41) aufweist, mittels der eine Bandverlängerung des bandförmigen Materials (11) in dessen Längsrichtung erzeugt wird.

4. Verfahren nach Anspruch 3, **dadurch gekennzeichnet, dass** die erzeugte Bandverlängerung im Bereich von 0,15 % - 12% liegt.

5. Verfahren nach Anspruch 3 oder 4, **dadurch gekennzeichnet, dass** die Planheitsoptimierungseinrichtung (39) eine Dressiergerüsteinrichtung (40) aufweist.

6. Verfahren nach Anspruch 5, **dadurch gekennzeichnet, dass** mit der Dressiergerüsteinrichtung (40) für das bandförmige Material (11) eine vorbestimmte Oberflächenrauheit erzeugt bzw. eingestellt wird.

7. Verfahren nach einem der Ansprüche 3 bis 6, **dadurch gekennzeichnet, dass** als bandförmiges Material (11) Warmband aus Metall, vorzugsweise aus Stahl, bearbeitet wird.

## Claims

1. Vacuum coating plant (10) for coating a strip-shaped material (11) of metal, comprising:
a conveying path (12) with transport means, particularly in the form of rollers, on which the strip-shaped material (11) is movable in a transport direction (T),
a coating chamber (14) in which vacuum can be generated, wherein the coating chamber (14) has an inlet region (16) and an outlet region (18) and thereby can be traversed by the strip-shaped material (11) along or on the conveying path (12) in the transport direction (T),
wherein at least one planarity optimisation device (39) through which the strip-shaped material (11) of metal can be guided in order to create a desired planarity therefor is arranged upstream of the coating chamber (14) as seen in transport direction (T) of the strip-shaped material (11),
**characterised in that**
the planarity optimisation device (39) is formed as a compact unit (K) in which a bending-straightening device (41) and a stretch leveller are combined to form a stretching-straightening/bending-straightening device (41).

2. Vacuum coating plant (10) according to claim 1, **characterised in that** the planarity optimisation device (39) additionally comprises a skin-pass mill stand.

3. Method of coating a strip-shaped material (11), particularly of metal, in which the strip-shaped material (11) is moved over a conveying path (12) in a transport direction (T) and is vacuum-coated within a coating chamber (14) in which a vacuum is applied, wherein the strip-shaped material (11) upstream of the coating chamber (14) as seen in transport direction (T) of the strip-shaped material (11) is optimised with respect to its planarity by a planarity optimisation device (39),
**characterised in that**
the planarity optimisation device (39) comprises a stretching-straightening/bending-straightening device (41) by means of which strip elongation of the strip-shaped material (11) in the longitudinal direction thereof is produced.

4. Method according to claim 3, **characterised in that** the strip elongation produced lies in the range of 0.15% to 12%.

5. Method according to claim 3 or 4, **characterised in that** planarity optimisation device (39) comprises a skin-pass mill stand.

6. Method according to claim 5, **characterised in that** a predetermined surface roughness for the strip-shaped material (6) is produced or set by the skin-pass mill stand (40).

7. Method according to any one of claims 3 to 6, **characterised in that** hot strip of metal, preferably of steel, is processed as strip-shaped material (11).

## Revendications

1. Installation de revêtement sous vide (10) pour le revêtement d'un matériau sous forme de bande (11) en métal, comprenant
une section de transport (12) avec des moyens de transport, en particulier sous la forme de rouleaux, sur lesquels le matériau sous forme de bande (11) est mobile dans une direction de transport (T),
une chambre de revêtement (14) dans laquelle un vide peut être généré, la chambre de revêtement (14) présentant une zone d'entrée (16) et une zone de sortie (18) et pouvant ainsi être traversée par le matériau sous forme de bande (11) le long ou sur la section de transport (12) dans la direction de transport (T),
dans laquelle - vue dans la direction de transport (T) du matériau sous forme de bande (11) - au moins un dispositif d'optimisation de la planéité (39) est disposé en amont de la chambre de revêtement (14), à travers lequel le matériau sous forme de bande (11) en métal peut être guidé afin de générer pour celui-ci une planéité souhaitée,
**caractérisée en ce que**
le dispositif d'optimisation de la planéité (39) est réalisé sous la forme d'une unité compacte (K) dans laquelle un dispositif de dressage par flexion (41) et un dresseur par traction sont combinés en un dispositif de dressage par traction et flexion (41).

2. Installation de revêtement sous vide (10) selon la revendication 1, **caractérisée en ce que** le dispositif d'optimisation de la planéité (39) présente en plus un dispositif de cage de skin-pass (40).

3. Procédé de revêtement d'un matériau sous forme de bande (11), en particulier en métal, dans lequel le matériau sous forme de bande (11) est déplacé sur une section de transport (12) dans une direction de transport (T) et est revêtu sous vide à l'intérieur d'une chambre de revêtement (14) dans laquelle un vide est appliqué,
dans lequel le matériau sous forme de bande (11) - vu dans la direction de transport (T) du matériau sous forme de bande (11) - est optimisé quant à sa planéité par un dispositif d'optimisation de la planéité (39) en amont de la chambre de revêtement (14), **caractérisé en ce que**
le dispositif d'optimisation de la planéité (39) présente un dispositif de dressage par traction et flexion (41) au moyen duquel un allongement de bande du matériau sous forme de bande (11) est généré dans sa direction longitudinale.

4. Procédé selon la revendication 3, **caractérisé en ce que** l'allongement de bande généré se situe dans la plage de 0,15 % - 12 %.

5. Procédé selon la revendication 3 ou 4, **caractérisé en ce que** le dispositif d'optimisation de la planéité (39) présente un dispositif de cage de skin-pass (40).

6. Procédé selon la revendication 5, **caractérisé en ce qu'**une rugosité de surface prédéterminée est générée ou réglée pour le matériau sous forme de bande (11) avec le dispositif de cage de skin-pass (40).

7. Procédé selon l'une des revendications 3 à 6, **caractérisé en ce que** de la bande à chaud en métal, de préférence en acier, est traitée en tant que matériau sous forme de bande (11).
